# EUROPÄISCHE PATENTSCHRIFT

(11) **EP 1 199 912 B1**
(45) Veröffentlichungstag und Bekanntmachung des Hinweises auf die Patenterteilung: **02.03.2005**
(21) Anmeldenummer: 01124317.7
(22) Anmeldetag: 19.10.2001
(51) Int. Cl.: H05K 1/02, H05K 7/02

(54) **Trägerstruktur zur räumlichen Formgebung für eine Leiterfolie und Verfahren hierfür**
Carrier structure for spatial shaping of a circuit foil and method therefor
Structure de support pour la formation spatiale d'une feuille de circuit et méthode associée

(30) Priorität: 19.10.2000 DE 10051884
(43) Veröffentlichungstag der Anmeldung: 24.04.2002
(73) Patentinhaber: Cherry GmbH, 91275 Auerbach (DE)
(72) Erfinder: Michel, Kurt, 91257 Pegnitz (DE); Ehmann, Stefan, 90411 Nürnberg (DE); Friedl, Roland, 91275 Auerbach (DE); Bauer, Günter, 92237 Sulzbach-Rosenberg (DE)
(74) Vertreter: Frohwitter, Bernhard, Dipl.-Ing.

(56) Entgegenhaltungen:
- EP-A- 0 386 279
- EP-A- 1 014 580
- CH-A- 607 543
- DE-A- 1 766 729
- DE-A- 4 436 523
- DE-A- 19 720 106

## Beschreibung

Die Erfindung betrifft eine Trägerstruktur zur räumlichen Formgebung für eine von der Trägerstruktur gehaltene und elektrische Leiterbahnen aufweisende flexible Leiterfolie. Die Erfindung betrifft desweiteren ein Verfahren zur räumlichen Formgebung für die Leiterfolie.

Es ist aus dem Stand der Technik bekannt, Trägerstrukturen vorzusehen, die flexiblen Leiterfolien eine räumliche Form geben und die Leiterfolien in dieser räumlichen Form halten.

Die Trägerstruktur weist mit Fixiermittel versehene Abschnitte auf, wobei die Fixiermittel zur Herstellung einer festen räumlichen Anordnung der Abschnitte zueinander miteinander in Eingriff treten können. Solch eine Trägerstruktur ist beispielsweise in EP-A-0 386 279. Die in dieser Druckschrift beschriebene Trägerstruktur wird in einem Spritzgußverfahren hergestellt, in dem die Leiterfolie mit einer die Trägerstruktur bildenden Spritzgußmasse umspritzt wird. Die geformte Trägerstruktur enthält zwei voneinander getrennte Abschnitte, die auf einer Seite der Leiterfolie gebildet sind. Die Abschnitte sind durch einen Abschnitt-freien Teil der Leiterfolie verbunden. Nachdem elektronische Teile an der Leiterfolie angebracht wurden, werden dann die Abschnitte in einem Kasten zusammengebaut in dem der Abschnitt-freie Teil der Leiterfolie verbogen wird.

Es ist daher Aufgabe der Erfindung, eine Trägerstruktur der hier in Rede stehenden Art bereitzustellen, die materialsparend ist und zusätzlich auch nach der Herstellung der Trägerstruktur noch eine Bestückung der Leiterfolie mit elektrischen Baulementen oder dergleichen ermöglicht, indem nach der Herstellung der Trägerstruktur Bereiche der Leiterfolie von außen her zugänglich bleiben.
Es sind weitere Aufgaben der Erfindung, eine Trägerstruktur der hier in Rede stehenden Art bereitzustellen, die eine mechanische Haltung der Leiterfolie und eine elektrische Verbindung zwischen den Leiterbahnen und einer Strom- oder Spannungsquelle ermöglicht.
Zudem ist es Aufgabe der Erfindung, ein Verfahren zur räumlichen Formgebung einer Leiterfolie mittels einer Trägerstruktur der hier in Rede stehenden Art anzugeben.

Die Aufgabe wird erfindungsgemäß dadurch gelöst, daß die Trägerstruktur als Randstege und Querstege aufweisendes Trägergitter ausgebildet ist.

Die Fixiermittel können auf verschiedene Arten ausgebildet sein. So kann eines der beiden Fixiermittel als Steckzapfen und das andere als Steckhülse ausgebildet sein. Die Herstellung einer festen räumlichen Anordnung der Abschnitte der Trägerstruktur zueinander entspricht dann einem Einführen der Steckzapfen in die Steckhülsen. Die Steckzapfen sind reibschlüssig in den Steckhülsen gehalten. Der Eingriff zwischen der Steckhülse und dem Steckzapfen kann daher durch Herausziehen des Steckzapfens aus der Steckhülse rückgängig gemacht werden. Soll eine dauerhafte Fixierung des Steckzapfens in der Steckhülse sichergestellt werden, kann beispielsweise eine Verklebung des Steckzapfens in der Steckhülse erfolgen.

Die Trägerstruktur kann die Leiterfolie auf verschiedene Weisen halten. In einem Ausführungsbeispiel weist die Trägerstruktur zu diesem Zweck Haltezapfen und die Leiterfolie Halteöffnungen auf. Die Haltezapfen der Trägerstruktur und die Halteöffnungen der Leiterfolie sind einander anzahl- und anordnungsmäßig zugeordnet. Die Trägerstruktur hält in diesem Ausführungsbeispiel die Leiterfolie, indem die Haltezapfen die Halteöffnungen durchgreifen. Um ein unverlierbares Halten der Leiterfolie seitens der Trägerstruktur sicherzustellen, können die Köpfe der Haltezapfen verstemmt werden. Das Halten der Leiterfolie durch die Trägerstruktur kann des weiteren dadurch bewirkt sein, daß die Leiterfolie in die Trägerstruktur eingeklebt ist. Schließlich ist es auch möglich, die Trägerstruktur durch ein Umspritzen oder Ausgießen der Leiterfolie mit einer Spritzgußmasse herzustellen. Das Halten der Leiterfolie durch die Trägerstruktur wird in diesem Fall durch das Anhaften der Spritzgußmasse an der Leiterfolie bewirkt. Die Spritzgußmasse ist hierbei vorzugsweise ein Kunststoff. Verfahrensökonomisch vorteilhaft ist, wenn auch die Fixiermittel während des Umspritzens oder Ausgießens der Leiterfolie mit der Spritzgußmasse hergestellt werden, da dann die Trägerstruktur und die Fixiermittel in einem einzigen Verfahrensschritt hergestellt werden.

Die Abschnitte der Trägerstruktur sind nach der Herstellung der Trägerstruktur durch Umspritzen oder Ausgießen der Leiterfolie gegeneinander beweglich und gewissermaßen nur durch die Leiterfolie zusammengehalten. Werden die Abschnitte unbeabsichtigt gegeneinander bewegt, kann dies zu einer Beschädigung der Leiterfolie im Bereich zwischen den beiden Abschnitten der Trägerstruktur führen. Um dies zu vermeiden, sind in einem Ausführungsbeispiel der Erfindung Bruchstege vorgesehen, die die Abschnitte der Trägerstruktur verbinden. Die Bruchstege verhindern eine unbeabsichtigte Bewegung der Abschnitte relativ zueinander. Sie sind, bevor der Leiterfolie eine räumliche Form gegeben wird, zu entfernen.

Die Leiterfolie kann mit einer Vielzahl elektrischer Bauelemente und/oder elektrischer Kontakelemente bestückt sein. Als elektrische Bauelemente kommen beispielsweise Widerstände, Kondensatoren, Spulen, Transistoren und dergleichen mehr in Betracht, die elektrischen Kontaktelemente können als mechanische, elektrische oder magnetische Schalter, Kontaktstifte und ähnliches ausgebildet sein.

Die Handhabung der Herstellung der Trägerstruktur wird besonders einfach, wenn diese vor der räumlichen Formgebung der Leiterfolie eben ausgebildet ist. Die Randstege, Querstege und gegebenenfalls Bruchstege der Trägerstruktur ebenso wie die Leiterfolie erstrecken sich in diesem Fall in einer Ebene.

Die Aufgabe wird zudem durch ein Verfahren der hier in Rede stehenden Art gelöst, das durch die folgenden Verfahrensschritte gekennzeichnet ist: [a] Herstellen der Trägerstruktur und der Fixiermittel durch Umspritzen oder Ausgießen der Leiterfolie und [b] Herstellen eines Eingriffes zwischen den Fixiermitteln. Indem also dem aus dem Stand der Technik bekannten Verfahrensschritt des Herstellens der Trägerstruktur durch Umspritzen oder Ausgießen der Leiterfolie der zusätzliche Verfahrensschritt des Herstellens eines Eingriffes zwischen den Fixiermitteln folgt, wird es auch nach Herstellung der Trägerstruktur möglich, durch Änderung der räumlichen Anordnung der Abschnitte der Trägerstruktur zueinander der Leiterfolie eine räumliche Form zu geben.

Für den Fall, daß die beiden Abschnitte der Trägerstruktur durch Bruchstege verbunden sind, sind diese zu entfernen, bevor der Leiterfolie eine räumliche Form gegeben wird.

Nach dem Verfahrensschritt [b] erfolgt in einer Ausführungsvariante des Verfahrens in einem Verfahrensschritt [c] ein Herstellen eines Trägergehäuses durch Umspritzen oder Ausgießen der Trägerstruktur mit einer Spritzgußmasse. In diesem Fall stellt die Trägerstruktur lediglich eine die räumliche Form der Leiterfolie für das Herstellen des Trägergehäuses aufrechterhaltende Zwischenstufe dar. Die Trägerstruktur ist nach der Herstellung des Trägergehäuses ein Teil desselben, von dem sie - insbesondere wenn zur Herstellung der Trägerstruktur und des Trägergehäuses die gleiche Spritzgußmasse verwendet wird - kaum mehr unterscheidbar ist.

Es ist möglich, die Leiterfolie vor dem Verfahrensschritt [a] oder zwischen den Verfahrensschritten [a] und [b] oder zwischen den Verfahrensschritten [b] und [c] mit elektrischen Bauelementen und/oder elektrischen Kontaktelementen zu bestücken.

Weitere Ausführungsbeispiele der erfindungsgemäßen Trägerstruktur und Ausführungsvarianten des erfindungsgemäßen Verfahrens sowie deren jeweilige Vorteile ergeben sich aus der nachstehenden Zeichnung, in der ein Ausführungsbeispiel der erfindungsgemäßen Trägerstruktur sowie eine Ausführungsvariante des erfindungsgemäßen Verfahrens näher beschrieben werden. Es zeigen
- Figur 1: ein Ausführungsbeispiel einer erfindungsgemäßen Trägerstruktur, bevor einer Leiterfolie eine räumliche Form gegeben wird,
- Figur 2: einen vergrößerten Ausschnitt aus der Trägerstruktur der Figur 1,
- Figur 3: die erfindungsgemäße Trägerstruktur der Figur 1, nachdem der Leiterfolie eine räumliche Form gegeben wurde,
- Figur 4: einen vergrößerten Ausschnitt aus der Trägerstruktur der Figur 3 und
- Figur 5: ein Trägergehäuse.

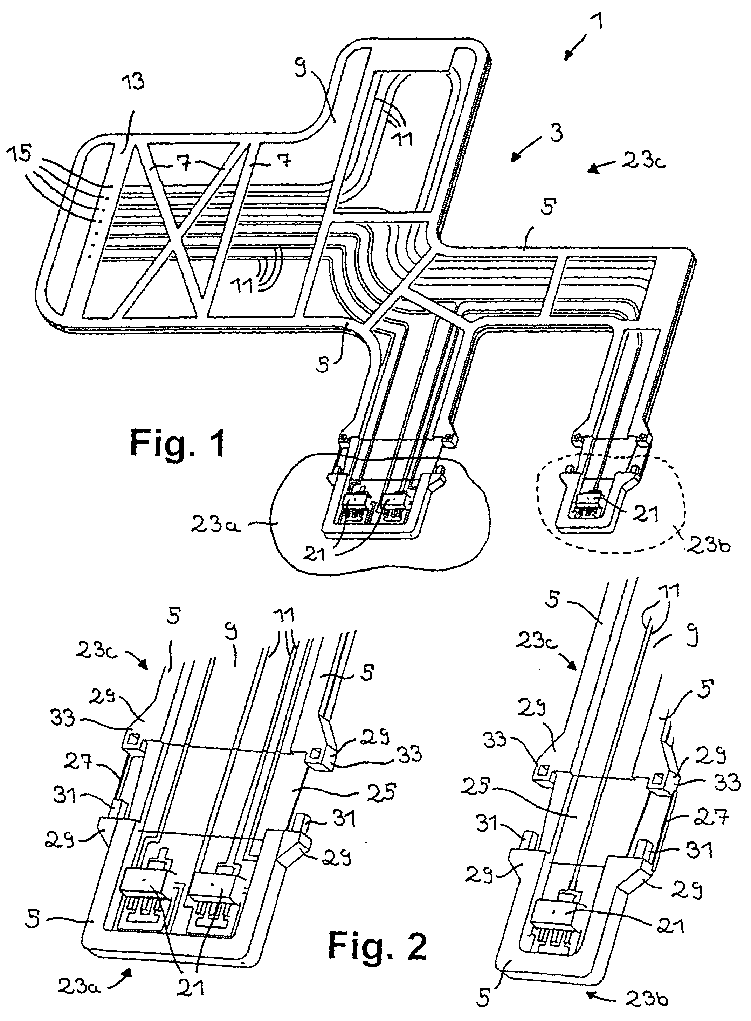

Figur 1 zeigt eine Trägerstruktur 1. Die Trägerstruktur 1 ist als ebenes Trägergitter 3 ausgebildet. Das Trägergitter 3 setzt sich aus einem Randsteg 5 und einer Mehrzahl von Querstegen 7 zusammen. Der Randsteg 5 berandet das Trägergitter 3, während die Querstege 7 verschiedene Bereiche des Randsteges 5 verbinden.

In das Trägergitter 3 ist eine flexible Leiterfolie 9 eingebettet. Die Leiterfolie 9 weist eine dem Trägergitter 3 entsprechende Form auf, weshalb der Rand der Leiterfolie 9 mit dem Randsteg 5 des Trägergitters 3 abschließt. Die Leiterfolie 9 liegt flächig an dem Randsteg 5 und den Querstegen 7 des Trägergitters 3 auf und haftet an diesen an. Sie ist daher genau wie das Trägergitter 3 eben und erstreckt sich in derselben Erstreckungsebene wie dieses. Aufgrund des Anhaftens der Leiterfolie 9 an dem Trägergitter 3, ist die Leiterfolie 9 von dem Trägergitter 3 gehalten. Das Trägergitter 3 bestimmt mithin die räumliche Form der Leiterfolie 9. Für den in Figur 1 dargestellten Zustand bedeutet dies, daß das ebene Trägergitter 3 beziehungsweise die ebene Trägerstruktur 1 die ebene Form der flexiblen Leiterfolie 9 bedingt.

Es sei angemerkt, daß die Leiterfolie 9 auch auf andere Arten von der Trägerstruktur 1 gehalten sein kann. So kann die Leiterfolie 9 in die Trägerstruktur 1 eingeklebt sein. Des weiteren können an der Trägerstruktur 1 Haltezapfen vorgesehen sein, die in der Leiterfolie 9 befindliche Halteöffnungen durchgreifen und deren Köpfe, um eine Unverlierbarkeit der Leiterfolie 9 sicherzustellen, verstemmt sind.

Die Leiterfolie 9 weist eine Vielzahl elektrischer Leiterbahnen 11 auf. Die elektrischen Leiterbahnen 1 verlaufen an der Oberfläche der Leiterfolie 9 und bilden dort ein Layout. Andere Anordnungen der elektrischen Leiterbahnen 11, beispielsweise im Falle einer Multilayer-Leiterfolie in deren Innerem, sind ebenso möglich.

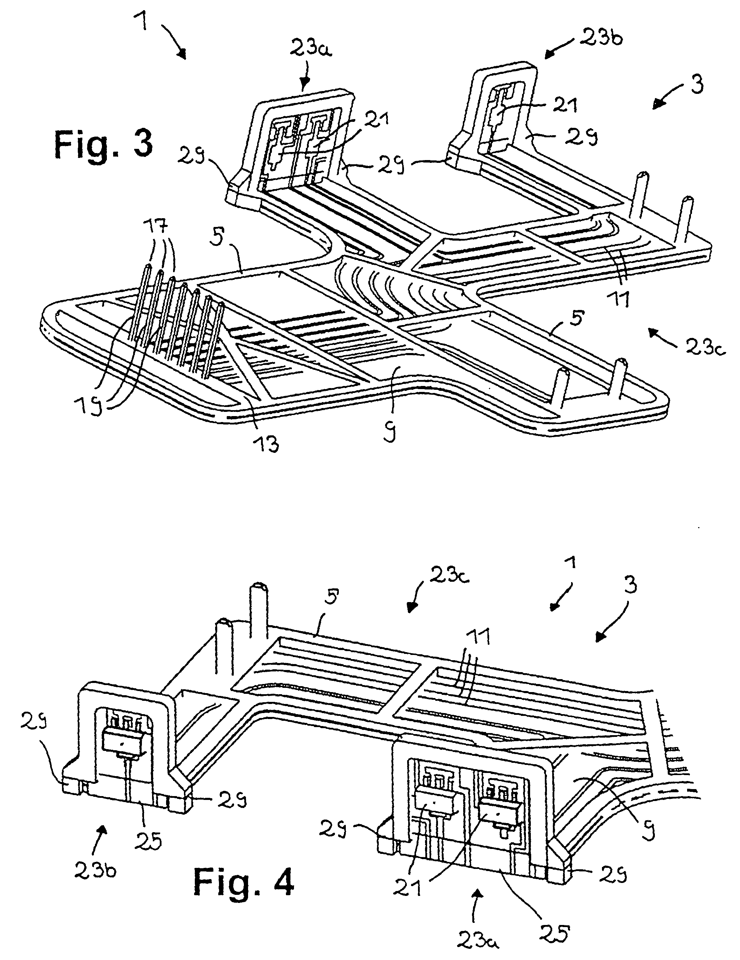

Die elektrischen Leiterbahnen 11 enden im Bereich eines seitlichen Randsteges 13 des Trägergitters 3. In diesem Bereich weist der seitliche Randsteg 13 eine Mehrzahl von Kontaktdurchbrüchen 15 auf. Jeder elektrischen Leiterbahn 11 der Leiterfolie 9 ist ein Kontaktdurchbruch 15 zugeordnet. Wie in Figur 3 zu sehen ist, ist in jedem Kontaktdurchbruch 15 ein als Kontaktstift 17 ausgebildetes elektrisches Kontaktelement 19 reibschlüssig gehalten. Die Kontaktelemente 19 sind mit den jeweils zugeordneten elektrischen Leiterbahnen 11 elektrisch leitend verbunden. Über die elektrischen Kontaktelemente 19 liegen die Leiterbahnen der Leiterfolie an einer (nicht dargestellten) Spannungs- oder Stromquelle an.

Die Leiterfolie 9 ist zudem mit einer Mehrzahl elektrischer Bauelemente 21 bestückt. Die elektrischen Bauelemente 21 sind in vorliegendem Ausführungsbeispiel als Widerstände ausgebildet und mit den Leiterbahnen 11 der Leiterfolie 9 elektrisch verbunden. Es besteht mithin eine durchgehende elektrische Verbindung zwischen den Kontaktstiften 17 (Figur 3), den elektrischen Leiterbahnen 11 und den Bauelementen 21.

Die Trägerstruktur 1 setzt sich aus drei Abschnitten 23 zusammen, nämlich einem Abschnitt 23a, der in Figur 1 durch eine durchgezogene geschlossene Linie markiert ist, einem Abschnitt 23b, der in Figur 1 durch eine gestrichelte geschlossene Linie markiert ist, und einem Abschnitt 23c, der bei der Trägerstruktur 1 der Figur 1 das Komplement zu den Abschnitten 23a und 23b darstellt, mithin in Figur 1 dem nicht durch die durchgezogene und gestrichelte Linie eingeschlossenen Abschnitt 23 der Trägerstruktur 1 entspricht.

In dem Abschnitt 23a ist die Leiterfolie 9 mit zwei elektrischen Baulementen 21, in dem Abschnitt 23b mit einem elektrischen Bauelement 21 bestückt.

Eine vergrößerte Darstellung der beiden Abschnitte 23a und 23b ist in Figur 2 zu sehen, wobei der Abschnitt 23a des Trägerstruktur 1 sowie ein Teil des Abschnittes 23c in der linken Bildhälfte der Figur 2, und der Abschnitt 23b der Trägerstruktur 1 sowie ein Teil des Abschnittes 23c in der rechten Bildhälfte der Figur 2 gezeigt sind.

Die linke Bildhälfte der Figur 2 macht deutlich, daß die beiden Abschnitte 23a und 23c durch einen Übergangsbereich 25 der Leiterfolie 9 sowie durch einen Bruchsteg 27 verbunden sind. Der Bruchsteg 27 verbindet die Abschnitte 23a und 23c der Trägerstruktur 1 im Übergangsbereich 25 der Leiterfolie 9, er ersetzt dort gewissermaßen den fehlenden Randsteg 5.

Im Übergangsbereich 25 weist die Trägerstruktur 1 vier Fixiermittel 29 auf. Zwei der Fixiermittel 29 sind dem Abschnitt 23a der Trägerstruktur 1 und zwei Fixiermittel 29 dem Abschnitt 23c der Trägerstruktur 1 zugeordnet. Die beiden dem Abschnitt 23a zugeordneten Fixiermittel 29 sind jeweils als Steckzapfen 31 und die beiden dem Abschnitt 23c zugeordneten Fixiermittel 29 als Steckhülsen 33 ausgebildet. Jeweils ein Steckzapfen 31 und eine Steckhülse 33 sind im Bereich des Randsteges 5 der Trägerstruktur 1 einander gegenüberliegend angeordnet. Die Steckzapfen 31 und die Steckhülsen 33 sind derart ausgebildet, daß sie miteinander in Eingriff treten können und der Steckzapfen 31 in der Steckhülse 33 reibschlüssig gehalten werden kann.

Es wird deutlich, daß nach einer Entfernung des Bruchsteges 27 die Steckzapfen 31 des Abschnittes 23a der Trägerstruktur 1 in die Steckhülsen 33 des Abschnittes 23c der Trägerstruktur 1 eingeführt werden können.

Für den in der rechten Bildhälfte von Figur 2 dargestellten Abschnitt 23b der Trägerstruktur 1 gilt das bereits für den Abschnitt 23a Dargelegte entsprechend.

Der Zustand der Trägerstruktur 1, in dem die Steckzapfen 31 in die Steckhülsen 33 der Trägerstruktur 1 eingeführt sind, ist in den Figuren 3 und 4 dargestellt.

Ein Vergleich des Zustandes der Trägerstruktur 1 gemäß Figuren 1 und 2 mit demjenigen gemäß Figuren 3 und 4 macht deutlich, daß bei ersterem die Abschnitte 23a und 23c und mithin die von den Abschnitten 23a und 23c gehaltenen Teile der Leiterfolie 9 parallel verlaufen und in derselben Ebene angeordnet sind, wohingegen bei letzterem die beiden Abschnitte 23a und 23c und mithin die von den Abschnitten 23a und 23c gehaltenen Teile der Leiterfolie 9 einen Winkel von ungefähr 90° einschließen. Entsprechendes gilt für die Abschnitte 23b und 23c der Trägerstruktur 1.

Die ebene Anordnung gemäß Figuren 1 und 2 ist also durch die gegenseitige Ineingriffnahme der Fixiermittel 29 in eine räumliche Anordnung übergegangen, die Fixiermittel 29 dienen mithin der räumlichen Formgebung für die flexible Leiterfolie 9. Die flexible Leiterfolie 9 wird durch die erfindungsgemäße Trägerstruktur 1 in einer räumlichen Form gehalten. Sie wird, wie insbesondere aus Figur 4 deutlich wird, im Übergangsbereich 25 zwischen den Abschnitten 23a und 23c beziehungsweise den Abschnitten 23b und 23c gebogen.

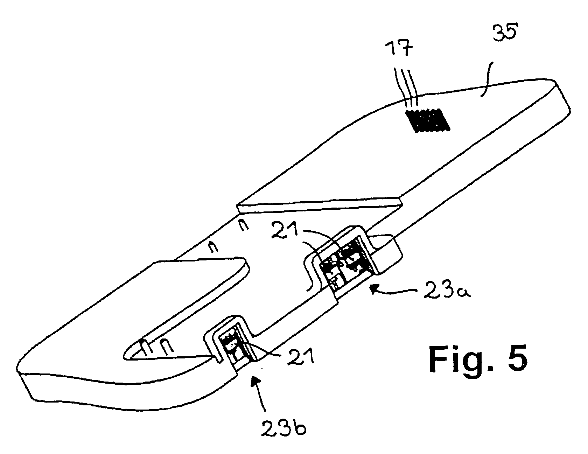

Figur 5 zeigt ein Trägergehäuse 35. Das Trägergehäuse 35 weist keine Gitter- beziehungsweise Netzstruktur auf, sondern ist massiv augebildet. Das Trägergehäuse 35 ist durch ein Umspritzen der Trägerstruktur 1 herstellt, wodurch die Trägerstruktur 1 ein Teil des Trägergehäuses 35 geworden ist. Die Trägerstruktur 1 und das Trägergehäuse 35 sind aus derselben Kunststoffspritzgußmasse herstellt, weshalb die Trägerstruktur 1 und das Trägergehäuse 35 kaum mehr zu unterscheiden sind. An dem fertigen Trägergehäuse 35 sind nur mehr die Kontaktstifte 17 und die elektrischen Baulemente 21 von außen sichtbar.

Im folgenden sei das erfindungsgemäße Verfahren unter Bezugnahme auf die Figuren der Zeichnung erläutert.

Der in Figuren 1 und 2 dargestellte Zustand entspricht dem Zustand nach Ausführung des Verfahrensschrittes [a], das heißt, die Trägerstruktur 1 und die Fixiermittel 29 sind durch Umspritzen der Leiterfolie 9 hergestellt. Der Zustand gemäß Figuren 3 und 4 entspricht dem Zustand nach Ausführen des Verfahrensschrittes [b], das heißt, die Fixiermittel 29 sind miteinander in Eingriff getreten. Zwischen dem Verfahrensschritt [a] und dem Verfahrensschritt [b] erfolgt ein Entfernen der Bruchstege 27.

Die Vorteile des erfindungsgemäßen Verfahrens unter Zuhilfenahme der erfindungsgemäßen Trägerstruktur 1 zeigen sich insbesondere dann, wenn nach den beiden Verfahrensschritten [a] und [b] ein weiterer Verfahrensschritt [c] erfolgt, in dem das Trägergehäuse 35 durch Umspritzen oder Ausgießen der Trägerstruktur 1 mit einer Spritzgußmasse hergestellt wird. Die in diesem Fall auch "Vorspritzling" genannte Trägerstruktur 1 dient dann lediglich dazu, die Leiterfolie 9 in einer gewünschten räumlichen Form zu fixieren, bevor durch Umspritzen der Trägerstruktur 1 das Trägergehäuse 35 hergestellt wird.

Die Bestückung der Leiterfolie 9 mit elektrischen Bauelementen 21 oder elektrischen Kontaktelementen 19 kann sowohl vor dem Verfahrensschritt [a], also vor dem Herstellen der Trägerstruktur 1, wie auch zwischen den Verfahrensschritten [a] und [b], also in dem Zustand gemäß Figuren 1 und 2, wie auch zwischen den Verfahrensschritten [b] und [c], das heißt in dem Zustand gemäß Figuren 3 und 4, erfolgen.

### Bezugszeichenliste

- 1: Trägerstruktur
- 3: Trägergitter
- 5: Randsteg
- 7: Quersteg
- 9: Leiterfolie
- 11: elektrische Leiterbahnen
- 13: seitlicher Randsteg
- 15: Kontaktdurchbrüche
- 17: Kontaktstift
- 19: elektrische Kontaktelemente
- 21: elektrische Bauelemente
- 23: Abschnitte der Trägerstruktur
- 23a: Abschnitt der Trägerstruktur (markiert durch eine durchgezogenen geschlossene Linie)
- 23b: Abschnitt der Trägerstruktur (markiert durch eine gestrichelte geschlossene Linie)
- 23c: Abschnitt der Trägerstruktur
- 25: Übergangsbereich der Leiterfolie
- 27: Bruchsteg
- 29: Fixiermittel
- 31: Steckzapfen
- 33: Steckhülse
- 35: Trägergehäuse

## Patentansprüche

1. Trägerstruktur (1) zur räumlichen Formgebung für eine von der Trägerstruktur (1) gehaltene und elektrische Leiterbahnen (11) aufweisende flexible Leiterfolie (9), wobei die Trägerstruktur (1) mindestens zwei jeweils mit mindestens einem Fixiermittel (29) versehene Abschnitte (23) aufweist, und die Fixiermittel (29) zur Herstellung einer festen räumlichen Anordnung der Abschnitte (23) zueinander miteinander in Eingriff treten können, **dadurch gekennzeichnet, daß** die Trägerstruktur (1) als Randstege (5) und Querstege (7) aufweisendes Trägergitter (3) ausgebildet ist.

2. Trägerstruktur nach Anspruch 1, **dadurch gekennzeichnet, daß** das eine Fixiermittel (29) als Steckzapfen (31) und das andere Fixiermittel (29) als Steckhülse (33) ausgebildet ist.

3. Trägerstruktur nach Anspruch 1 oder 2, **dadurch gekennzeichnet, daß** die Trägerstruktur (1) Haltezapfen und die Leiterfolie (9) Halteöffnungen aufweist.

4. Trägerstruktur nach einem der vorhergehenden Ansprüche, **dadurch gekennzeichnet, daß** die Leiterfolie (9) in die Trägerstruktur (1) eingeklebt ist.

5. Trägerstruktur nach Anspruch 1 oder 2, **dadurch gekennzeichnet, daß** die Trägerstruktur durch Umspritzen oder Ausgießen der Leiterfolie (9) mit einer Spritzgußmasse hergestellt ist.

6. Trägerstruktur nach Anspruch 5, **dadurch gekennzeichnet, daß** die Fixiermittel (29) während des Umspritzens oder Ausgießens der Leiterfolie (9) mit einer Spritzgußmasse hergestellt sind.

7. Trägerstruktur nach einem der vorhergehenden Ansprüche, **dadurch gekennzeichnet, daß** die Trägerstruktur (1) Bruchstege (27) aufweist, die die Abschnitte (23a, 23c und 23b, 23c) der Trägerstruktur (1) verbinden.

8. Trägerstruktur nach Anspruch 7, **dadurch gekennzeichnet, daß** die Bruchstege (27) während des Umspritzens oder Ausgießens der Leiterfolie (9) mit einer Spritzgußmasse hergestellt sind.

9. Trägerstruktur nach einem der vorhergehenden Ansprüche, **dadurch gekennzeichnet, daß** die Leiterfolie (9) mit einer Vielzahl elektrischer Bauelemente (21) und/oder elektrischer Kontaktelemente (19) bestückt ist.

10. Trägerstruktur nach einem der vorhergehenden Ansprüche, **dadurch gekennzeichnet, daß** die Trägerstruktur (1) vor der räumlichen Formgebung der Leiterfolie (9) eben ausgebildet ist.

11. Verfahren zur räumlichen Formgebung für eine von einer Trägerstruktur (1) gehaltene und elektrische Leiterbahnen (11) aufweisende flexible Leiterfolie (9), nach Ansprüche 6 bis 10, **gekennzeichnet durch** die folgenden Verfahrensschritte: [a] Herstellen der Trägerstruktur (1) und der Fixiermittel (29) **durch** Umspritzen oder Ausgießen der Leiterfolie (9) und [b] Herstellen eines Eingriffes zwischen den Fixiermitteln (29).

12. Verfahren nach Anspruch 11, **dadurch gekennzeichnet, daß** zwischen den Verfahrensschritten [a] und [b] gegebenenfalls Bruchstege (27) entfernt werden.

13. Verfahren nach einem der Ansprüche 11 oder 12, **dadurch gekennzeichnet, daß** nach dem Verfahrensschritt [b] in einem Verfahrensschritt [c] ein Herstellen eines Trägergehäuses (35) durch Umspritzen oder Ausgießen der Trägerstruktur (1) mit einer Spritzgußmasse erfolgt.

14. Verfahren nach einem der Ansprüche 11 bis 13, **dadurch gekennzeichnet, daß** vor dem Verfahrensschritt [a] oder zwischen den Verfahrensschritten [a] und [b] ein Bestücken der Leiterfolie (9) mit elektrischen Bauelementen (21) und/oder elektrischen Kontaktelementen (19) erfolgt.

15. Verfahren nach Anspruch 13, **dadurch gekennzeichnet, daß** ein Bestücken der Leiterfolie (9) mit elektrischen Bauelementen (21) und / oder elektrischen Kontaktelementen (19) zwischen den Verfahrensschritten [b] und [c] erfolgt.

## Claims

1. A carrier structure (1) for shaping in space a flexible conductive foil (9) held by the carrier structure (1) and provided with electrically conductive tracks (11), wherein the carrier structure (1) comprises at least two sections (23) each provided with at least one securing mechanism (29), and the securing mechanisms (29) are mutually engageable to provide a fixed spatial arrangement between the sections (23), **characterised in that** the carrier structure (1) is formed as a carrier lattice (3) comprising edge-pieces (5) and transverse bridges (7).

2. The carrier structure according to claim 1, **characterised in that** one securing mechanism (29) is formed as a plug-in pin (31) and the other securing mechanism (29) as a plug-in socket (33).

3. The carrier structure according to claim 1 or 2, **characterised in that** the carrier structure (1) has holding pins and the conductive foil (9) has holding openings.

4. The carrier structure according to any one of the preceding claims, **characterised in that** the conductive foil (9) is glued into the carrier structure (1).

5. The carrier structure according to claim 1 or 2, **characterised in that** the carrier structure is formed by injection-moulding a moulding mass around the conductive foil (9) or by casting the conductive foil (9) with a moulding mass.

6. The carrier structure according to claim 5, **characterised in that** the securing mechanisms (29) are formed during the injection-moulding of a moulding mass around the conductive foil (9) or the casting of the conductive foil (9) with a moulding mass.

7. The carrier structure according to any one of the preceding claims, **characterised in that** the carrier structure (1) has breakable bridges (27) which connect the sections (23a, 23c and 23b, 23c) of the carrier structure (1).

8. The carrier structure according to claim 7, **characterised in that** the breakable bridges (27) are formed during the injection-moulding of a moulding mass around the conductive foil (9) or the casting of the conductive foil (9) with a moulding mass.

9. The carrier structure according to any one of the preceding claims, **characterised in that** the conductive foil (9) is provided with a plurality of electrical components (21) and/or electrical contact elements (19).

10. The carrier structure according to any one of the preceding claims, **characterised in that** the carrier structure (1) is formed planarly before the spatial shaping of the conductive foil (9).

11. A method for shaping in space a flexible conductive foil (9) held by a carrier structure (1) and provided with electrically conductive tracks (11) according to claims 6 to 10, **characterised by** the following steps: [a] manufacturing the carrier structure (1) and the securing mechanisms (29) by injection-moulding around or casting the conductive foil (9) and [b] generating an engagement between the securing mechanisms (29).

12. The method according to claim 11, **characterised in that** between the steps [a] and [b] breakable bridges (27) are removed if necessary.

13. The method according to one of the claims 11 or 12, **characterised in that** after step [b], in a step [c], manufacturing of a carrier housing (35) by injection-moulding a moulding mass around the carrier structure (1) or by casting the carrier structure (1) with a moulding mass is effected.

14. The method according to one of the claims 11 to 13, **characterised in that** before step [a] or between the steps [a] and [b] the conductive foil (9) is provided with electrical components (21) and/or electrical contact elements (19).

15. The method according to claim 13, **characterised in that** the conductive foil (9) is provided with electrical components (21) and/or electrical contact elements (19) between the steps [b] and [c].

## Revendications

1. Structure porteuse (1) pour le façonnage spatial d'un film de circuit imprimé (9) souple présentant des pistes (11) de circuit imprimé maintenues par la structure porteuse (1) et électriques, la structure porteuse (1) présentant au moins deux tronçons (23) dotés chacun d'au moins un moyen de fixation (29) et les moyens de fixation (29) pouvant s'engager l'un dans l'autre pour réaliser une disposition, fixe dans l'espace, des tronçons (23) entre eux, **caractérisée en ce que** la structure porteuse (1) est en forme de grille porteuse (3) présentant des entretoises marginales (5) et des entretoises transversales (7).

2. Structure porteuse selon la revendication 1, **caractérisée en ce qu'**un moyen de fixation (29) a la forme d'un pivot enfichable (31) et l'autre moyen de fixation (29) d'un clip (33).

3. Structure porteuse selon la revendication 1 ou 2, **caractérisée en ce que** la structure porteuse (1) présente des pivots de retenue et le film de circuit imprimé (9) des ouvertures de retenue.

4. Structure porteuse selon l'une quelconque des revendications précédentes, **caractérisée en ce que** le film de circuit imprimé (9) est collé dans la structure porteuse (1).

5. Structure porteuse selon la revendication 1 ou 2, **caractérisée en ce que** la structure porteuse est fabriquée par aspersion ou arrosage du film de circuit imprimé (9) par une matière de moulage par injection.

6. Structure porteuse selon la revendication 5, **caractérisée en ce que** les moyens de fixation (29) sont fabriqués pendant l'aspersion ou l'arrosage du film de circuit imprimé (9) par une matière de moulage par injection.

7. Structure porteuse selon l'une quelconque des revendications précédentes, **caractérisée en ce que** la structure porteuse (1) présente des nervures de rupture (27) qui relient les tronçons (23a, 23c et 23b, 23c) de la structure porteuse (1).

8. Structure porteuse selon la revendication 7, **caractérisée en ce que** les nervures de rupture (27) sont réalisées pendant l'aspersion ou l'arrosage du film de circuit imprimé (9) par une matière de moulage par injection.

9. Structure porteuse selon l'une quelconque des revendications précédentes, **caractérisée en ce que** le film de circuit imprimé (9) est équipé d'un grand nombre de composants électriques (21) et/ou de contacteurs électriques (19).

10. Structure porteuse selon l'une quelconque des revendications précédentes, **caractérisée en ce que** la structure porteuse (1) est plane avant le façonnage spatial du film de circuit imprimé (9).

11. Procédé de façonnage spatial d'un film de circuit imprimé (9) souple maintenu par une structure porteuse (1) et présentant des pistes de circuit imprimé électriques (11), selon les revendications 6 à 10, **caractérisé par** les étapes suivantes [a] fabrication de la structure porteuse (1) et des moyens de fixation (29) par aspersion ou arrosage du film de circuit imprimé (9) et [b] fabrication d'une prise entre les moyens de fixation (29).

12. Procédé selon la revendication 11, **caractérisé en ce que,** entre les étapes [a] et [b], on enlève le cas échéant des nervures de rupture (27).

13. Procédé selon l'une quelconque des revendications 11 ou 12, **caractérisé en ce qu**'après l'étape [b], on fabrique, dans une étape [c], un boîtier de support (35) par aspersion ou arrosage de la structure porteuse (1) par une matière de moulage par injection.

14. Procédé selon l'une quelconque des revendications 11 à 13, **caractérisé en ce qu**'avant l'étape [a] ou entre les étapes [a] et [b], on équipe le film de circuit imprimé (9) de composants électriques (21) et/ou de contacteurs électriques (19).

15. Procédé selon la revendication 13, **caractérisé en ce qu'**entre les étapes [b] et [c] on équipe le film de circuit imprimé (9) de composants électriques (21) et/ou de contacteurs électriques (19).
